(19) Europäisches Patentamt
European Patent Office
Office européen des brevets

(11) **EP 2 378 305 B1**

(12) **FASCICULE DE BREVET EUROPEEN**

(45) Date de publication et mention
de la délivrance du brevet:
**11.09.2013 Bulletin 2013/37**

(51) Int Cl.:
*G01R 33/025* *(2006.01)*    *G01C 17/38* *(2006.01)*
*G01V 3/08* *(2006.01)*    *G01V 3/165* *(2006.01)*

(21) Numéro de dépôt: **11162318.7**

(22) Date de dépôt: **13.04.2011**

(54) **Procédé et dispositif de compensation d'une mesure d'un champ magnétique, procédé et système de localisation d'un objet**

Methode und Vorrichtung zur Kompensierung eines gemessenen Magnetfeldes, Methode und System zur Lokalisierung eines Objektes.

Method and apparatus for compensating the measurement of a magnetic field, method and system for localizing an object

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.04.2010 FR 1052836**

(43) Date de publication de la demande:
**19.10.2011 Bulletin 2011/42**

(73) Titulaire: **Commissariat à l'Énergie Atomique et aux Énergies Alternatives**
**75015 Paris (FR)**

(72) Inventeurs:
• **Cattin, Viviane**
  **38120 SAINT EGREVE (FR)**
• **Billeres, Malvina**
  **38000 GRENOBLE (FR)**

(74) Mandataire: **Colombo, Michel et al**
**Brevinnov**
**310 avenue Berthelot**
**69008 Lyon (FR)**

(56) Documents cités:
**WO-A1-2009/138441    US-A- 5 134 369**
**US-A- 5 182 514    US-A1- 2008 309 327**

**Description**

L'invention concerne un procédé et un dispositif de compensation d'une mesure d'un champ magnétique. L'invention concerne également un procédé et un système de localisation d'un objet ainsi qu'un support d'enregistrement d'informations pour la mise en oeuvre de ces procédés.

Le déposant connaît un procédé de compensation d'une mesure d'un champ magnétique comportant l'émission, en présence d'un perturbateur magnétique, d'un champ magnétique par une source monoaxe située d'un côté du perturbateur magnétique, le moment magnétique de cette source étant connu.

Un perturbateur magnétique est ici défini comme étant tout objet qui altère ou déforme les lignes de champ d'un champ magnétique émis à proximité. Par exemple, le perturbateur peut être une pièce conductrice. Dans ce cas, l'altération des lignes de champ magnétique est due à l'apparition de courants de Foucault (« Eddy Current ») dans la pièce conductrice. La pièce conductrice est par exemple une pièce métallique. Le perturbateur peut également être une pièce magnétique telle qu'une pièce paramagnétique ou ferromagnétique. Une pièce est considérée comme magnétique si sa perméabilité relative est différente de un.

La compensation d'une mesure du champ magnétique consiste à corriger cette mesure pour se rapprocher de la mesure qui serait obtenue en absence du perturbateur magnétique.

Une source monoaxe de champ magnétique est une source qui émet préférentiellement le champ magnétique le long d'un seul axe. Par exemple, une bobine dont les spires sont enroulées autour d'un même axe est une source monoaxe de champ magnétique et l'axe d'émission préférentiel est confondu avec l'axe d'enroulement des spires.

Une source triaxe de champ magnétique émet un champ magnétique le long de trois axes d'émission non colinéaires entre eux. Par exemple, un tel émetteur est formé de plusieurs sources monoaxes de champ magnétique alignées, respectivement, sur chacun des axes d'émission.

De façon similaire, une source au moins triaxe est une source qui émet des champs magnétiques le long de trois ou plus axes non colinéaires.

On définit également un capteur triaxe de champ magnétique comme étant un capteur apte à mesurer la direction du champ magnétique. Typiquement, à cet effet, ces capteurs mesurent l'amplitude de la projection du champ magnétique sur trois axes de mesure non colinéaires entre eux. Ainsi, ces capteurs permettent de mesurer la direction du champ magnétique et, généralement, en plus l'amplitude de ce champ magnétique.

Les procédés de compensation de mesure du champ magnétique sont particulièrement utilisés au sein de procédés de localisation d'un objet à l'aide d'un système magnétique. En effet, si le champ magnétique mesuré utilisé pour localiser un objet est perturbé, la localisation de l'objet est alors erronée. Ceci peut avoir des conséquences particulièrement néfastes lorsque le procédé de localisation est utilisé en médecine pour localiser une sonde ou un cathéter à l'intérieur d'un corps humain. En effet, pour de telles applications, la fiabilité de la localisation de la sonde est très importante. Or, dans le milieu médical, il existe de nombreux perturbateurs magnétiques susceptibles de fausser la localisation. Par exemple, le perturbateur magnétique peut être une table d'opération, l'armature métallique d'un autre appareil placé à proximité du patient, ...etc.

Plusieurs méthodes ont déjà été proposées pour compenser les mesures perturbées du champ magnétique. Ces méthodes font appel à des calculs complexes ou à de la calibration de l'environnement.

De l'état de la technique est également connu de :

- US5 134 369 A
- WO2009/138441 A1,
- US2008/309327 A1,
- US5 182 514 A.

L'invention vise à remédier à ce problème en compensant simplement la présence d'un perturbateur magnétique.

Elle a donc pour objet un procédé de compensation comportant :

- la détermination d'une position et d'un moment magnétique d'une image de la source située de l'autre côté du perturbateur magnétique à partir d'une ou plusieurs mesures du champ magnétique émis réalisées par au moins un capteur magnétique dont la position et l'orientation par rapport à la source sont connues, la position et le moment magnétique de l'image minimisant la relation suivante pour chaque capteur :

$$\vec{B}_{me}-(\vec{B}_S+\vec{B}_I)\ ,$$

où :

- $\overleftrightarrow{B}_{me}$ est le champ magnétique mesuré par le capteur en présence du perturbateur magnétique,
- $\overleftrightarrow{B}_S$ est le champ magnétique qui serait mesuré par le capteur en absence du perturbateur magnétique, et
- $B_I$ est le champ magnétique fictif émis par l'image qui serait mesuré par le capteur en absence du perturbateur magnétique, et

- la soustraction du champ magnétique émis par cette image à la mesure du champ magnétique réalisée par un capteur en présence du perturbateur magnétique pour compenser cette mesure.

Le procédé ci-dessus modélise les perturbations du champ magnétique causées par le perturbateur magnétique comme étant un champ magnétique émis par l'image de la source par rapport à ce perturbateur magnétique. La compensation de toute mesure du champ magnétique émis par cette source est alors très simple puisqu'il suffit de soustraire au champ magnétique mesuré celui émis par l'image de cette source. De plus en champ lointain l'image de la source est vue comme un dipôle magnétique dont l'équation du champ rayonné est connue et présente une faible complexité mathématique. Ce procédé est donc particulièrement simple à implémenter et à utiliser.

De plus, le procédé ci-dessus fonctionne quel que soit le nombre d'axes de mesure perturbés par le perturbateur magnétique. Ainsi, contrairement à d'autres procédés, il ne nécessite pas l'existence d'au moins une mesure non perturbée selon au moins un axe de mesure.

Enfin, ce procédé fonctionne quelle que soit la nature du perturbateur magnétique, c'est-à-dire que le perturbateur magnétique peut aussi bien être une pièce conductrice qu'une pièce magnétique ou les deux à la fois.

Les modes de réalisation de ce procédé de compensation peuvent comporter une ou plusieurs des caractéristiques suivantes :

■ lors de la détermination de la position et du moment magnétique de l'image au moins une relation supplémentaire issue de la théorie des images en électromagnétisme est utilisée, la ou les relations supplémentaires étant choisies dans l'ensemble suivant :

-

$$M_i = M_S \left( \frac{1-\mu_r}{1+\mu_r} \right) \left( \frac{1-\sigma}{1+\sigma} \right) \quad \text{ou} \quad M_i = M_S \left( \frac{1-\mu_r}{1+\mu_r} \right) \quad \text{ou} \quad M_i = M_S \left( \frac{1-\sigma}{1+\sigma} \right),$$

où :

- $M_i$ et $M_s$ sont les moments magnétiques, respectivement, de l'image et de la source, et
- $\sigma$ et $\mu_r$ sont respectivement, la conductivité et la perméabilité relative du perturbateur magnétique,

- la distance la plus courte qui sépare la source du perturbateur magnétique est égale à la distance la plus courte qui sépare l'image de cette source du même perturbateur magnétique, et
- la composante normale du champ magnétique à la traversée d'une face du perturbateur magnétique est conservée de part et d'autre de cette face;

■ le procédé comprend :

- la détermination de la position et du moment magnétique d'une image de la source uniquement à partir de mesures du champ magnétique, en quadrature de phase par rapport au champ magnétique émis par cette source, réalisées par le ou les capteurs dont la position et l'orientation par rapport à la source sont connues, et
- la détermination de la position et du moment d'une autre image de la même source uniquement à partir des mesures du champ magnétique, en phase avec le champ magnétique émis par cette source, réalisées par le ou les capteurs dont la position et l'orientation par rapport à la source sont connues;

■ le procédé comprend le calcul du module efficace du champ magnétique à partir de mesures du champ magnétique en phase et en quadrature de phase par rapport au champ magnétique émis par la source réalisées par le ou les capteurs dont la position et l'orientation par rapport à la source sont connues et la détermination de la position et du moment magnétique d'au moins une image de la source à partir du module du champ magnétique;

■ le procédé comprend :

- la détermination de la position et du moment magnétique de plusieurs images de la même source à partir des mêmes mesures du champ magnétique réalisées par plusieurs capteurs dont les positions et les orientations sont connues par rapport à la source, et
- la soustraction du champ magnétique émis par ces images à la mesure du champ magnétique réalisée par un capteur en présence du perturbateur magnétique pour compenser cette mesure;

■ chaque image de la source est modélisée comme étant un dipôle magnétique.

Ces modes de réalisation du procédé de compensation présentent en outre les avantages suivants :

- utiliser une relation supplémentaire issue de la théorie des images en électromagnétisme permet de limiter le nombre de capteurs ou de simplifier les capteurs nécessaires pour déterminer la position et le moment magnétique de l'image de la source ;
- utiliser deux images issues, respectivement, des mesures en phase et en quadrature de phase permet d'améliorer la compensation des mesures du champ magnétique quand celles-ci sont perturbées par un perturbateur magnétique à la fois conducteur et perméable,
- utiliser le module efficace du champ magnétique permet également d'améliorer la compensation des mesures du champ magnétique quand celles-ci sont perturbées par un perturbateur magnétique à la fois conducteur et perméable;
- l'utilisation de plusieurs images de la source permet d'améliorer la compensation de la mesure dans le cas où le perturbateur magnétique s'éloigne des conditions théoriques permettant d'utiliser la théorie des images en électromagnétisme ;
- modéliser l'image de la source comme étant un dipôle magnétique simplifie les calculs.

L'invention a également pour objet un procédé de localisation d'un objet comportant :

- l'émission, en présence d'un perturbateur magnétique, d'un champ magnétique par une source monoaxe située d'un côté du perturbateur magnétique, le moment magnétique de cette source étant connu,
- la mesure du champ magnétique émis par un capteur fixé sans aucun degré de liberté à l'objet,
- la localisation de l'objet par rapport à la source à partir de la mesure de ce capteur, et
- lors de la localisation, la mesure du capteur est compensée à l'aide du procédé de compensation ci-dessus.

Les modes de réalisation de ce procédé de localisation peuvent comporter la caractéristique suivante:

- la localisation comporte la détermination des distances qui séparent le capteur à localiser de la source et de son ou ses images.

L'invention a également pour objet un support d'enregistrement d'informations comportant des instructions pour l'exécution d'un des procédés ci-dessus, lorsque ces instructions sont exécutées par un calculateur électronique.

L'invention a également pour objet un dispositif de compensation d'une mesure d'un champ magnétique, ce dispositif comportant :

- une source monoaxe située d'un côté d'un perturbateur magnétique, cette source étant apte à émettre un champ magnétique en présence de ce perturbateur magnétique, le moment magnétique de cette source étant connu,
- au moins un capteur du champ magnétique dont la position et l'orientation par rapport à la source magnétique sont connues,
- un compensateur apte à :

  • déterminer la position et le moment magnétique d'une image de la source située de l'autre côté du perturbateur magnétique à partir d'une ou plusieurs mesures du champ magnétique émis par la source réalisées par le ou les capteurs, la position et le moment magnétique de l'image minimisant la relation suivante pour chaque capteur :

$$\vec{B}_{\text{me}} - (\vec{B}_S + \vec{B}_I) \ ,$$

où :

- $\overleftrightarrow{B}_{me}$ est le champ magnétique mesuré par le capteur en présence du perturbateur magnétique,
- $\overleftrightarrow{B}_S$ est le champ magnétique qui serait mesuré par le capteur en absence du perturbateur magnétique, et
- $B_I$ est le champ magnétique fictif émis par l'image qui serait mesuré par le capteur en absence du perturbateur magnétique, et

- à soustraire le champ magnétique émis par cette image à la mesure du champ magnétique réalisée par un capteur pour compenser cette mesure.

Enfin, l'invention a également pour objet un système de localisation comportant :

- au moins une source monoaxe située d'un côté d'un perturbateur magnétique, cette source étant apte à émettre un champ magnétique en présence de ce perturbateur magnétique, le moment magnétique de cette source étant connu,
- au moins un capteur du champ magnétique émis par la source, ce capteur étant fixé sans aucun degré de liberté à l'objet à localiser, et
- un module de localisation de la position du capteur par rapport à la source à partir de la mesure du capteur, et
- le dispositif ci-dessus de compensation de la mesure utilisée par le module de localisation.

L'invention sera mieux comprise à la lecture de la description qui va suivre, donnée uniquement à titre d'exemple non limitatif et faite en se référant aux dessins sur lesquels :

- la figure 1 est une illustration schématique d'un premier mode de réalisation d'un système de localisation d'un objet,
- la figure 2 est une illustration schématique d'une source monoaxe de champ magnétique utilisée dans le système de la figure 1,
- la figure 3 est une illustration schématique d'un capteur triaxe de champ magnétique utilisé dans le système de la figure 1,
- la figure 4 est un organigramme d'un procédé de localisation d'un objet et de compensation de mesures perturbées,
- la figure 5 est une illustration schématique d'un deuxième mode de réalisation d'un système de localisation d'un objet,
- les figures 6 et 7 sont des illustrations schématiques, respectivement, de troisième et quatrième modes de réalisation d'un système de localisation d'un objet.

Dans ces figures, les mêmes références sont utilisées pour désigner les mêmes éléments.
Dans la suite de cette description, les caractéristiques et fonctions bien connues de l'homme du métier ne sont pas décrites en détail.

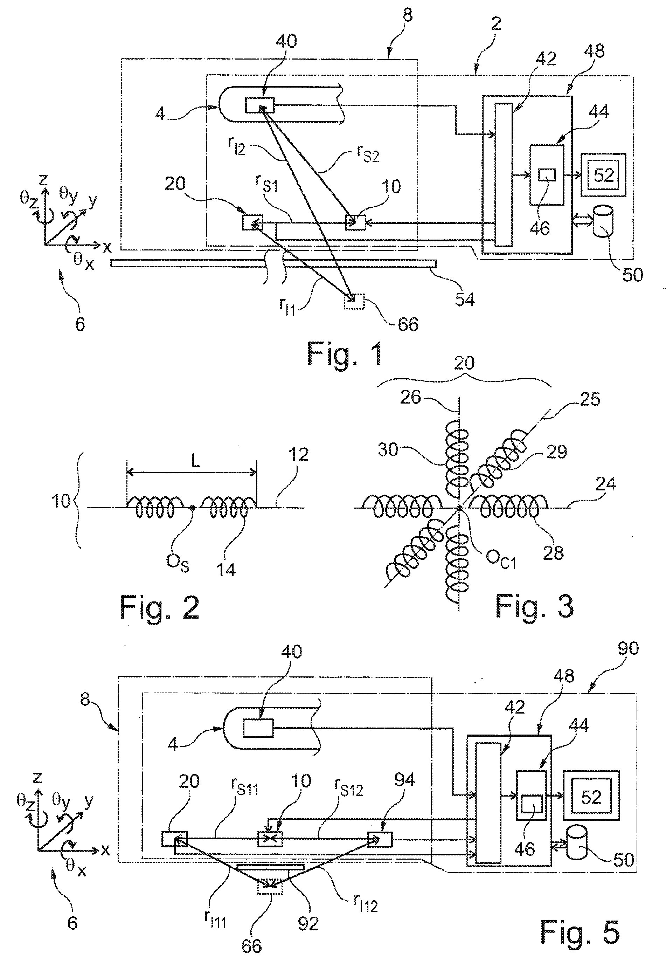

La figure 1 représente un système 2 de localisation d'un objet 4 dans un référentiel 6. L'objet 4 est par exemple une sonde ou un cathéter introduit dans un corps humain 8. L'objet 4 est mobile dans le référentiel 6.
Le référentiel 6 est un référentiel fixe présentant trois axes orthogonaux X, Y et Z.
La localisation de l'objet 4 dans le référentiel 6 consiste à trouver sa position x, y, z et son orientation $\theta_x$, $\theta_y$ et $\theta_z$. Les angles $\theta_x$, $\theta_y$ et $\theta_z$ représentent l'orientation de l'objet 4 respectivement par rapport aux axes X, Y et Z.
Le système 2 comprend une source 10 de champ magnétique. La position de la source 10 est connue dans le référentiel 6. Par exemple, la source 10 est fixe dans ce référentiel 6. Cette source 10 est ici une source monoaxe qui émet un champ magnétique le long d'un axe 12 (figure 2) parallèle à l'axe Z. Par exemple, la source 10 est constituée d'une seule bobine 14 (figure 2) enroulée autour de l'axe 12. Ici, cette bobine est divisée en deux groupes identiques de spires réparties de façon symétrique de part et d'autre d'un point $O_s$ le long de l'axe d'enroulement. Chaque groupe de spires est bobiné dans le même sens le long de l'axe d'enroulement. La plus grande dimension L de cette source 10 est donc ici égale à la longueur de la bobine 14. Par exemple, la distance L est égale à 15 mm.
Le champ magnétique généré par cette source 10 en un point espacé de la source 10 par une distance supérieure à 2L et, de préférence, supérieure à 3L ou 4L peut être considéré comme étant émis par une source ponctuelle de champ magnétique confondue avec le point $O_s$. Le point $O_s$ est le centre de la source 10.
Le système 2 comprend également un capteur 20 dont la position est connue par rapport à la source 10. Par exemple, la position du capteur 20 est fixe. Typiquement, la source 10 et le capteur 20 sont solidaires à cet effet d'un même substrat rigide.
La distance qui sépare la source 10 du capteur 20 est supérieure à 2L et de préférence à 3L ou 4L de manière à ce que le champ magnétique généré au niveau du capteur 20 par la source 10 puisse être considéré comme étant généré par une source dipolaire.
Le capteur 20 est par exemple un capteur triaxe représenté plus en détail sur la figure 3. Ce capteur mesure le champ magnétique reçu selon trois axes non colinéaires 24 à 26. Ici, ces axes 24 à 26 de mesure sont orthogonaux entre eux. A cet effet, le capteur 20 incorpore par exemple trois transducteurs monoaxes 28 à 30. Chacun de ces transducteurs présente une direction de mesure le long de laquelle sa sensibilité au champ magnétique est maximale. Ici, les directions de mesure des transducteurs 28 à 30 sont confondues, respectivement, avec les axes 24 à 26.

Par exemple, les transducteurs 28 à 30 sont des bobines enroulées, respectivement, autour des axes 24 à 26.

A titre d'illustration, de façon similaire à ce qui a été décrit en regard de la figure 2, chacune des bobines 28 à 30 est divisée en deux groupes identiques de spires réparties de façon symétrique de part et d'autres d'un point $O_{c1}$ correspondant à l'intersection des axes 24 à 26. Le champ magnétique mesuré par le capteur 20 est donc le champ magnétique existant au niveau du point $O_{c1}$. Le point $O_{c1}$ constitue le centre du capteur 20.

Le système 2 comporte aussi un autre capteur 40 de champ magnétique fixé sans aucun degré de liberté à l'objet 4. Ce capteur 40 est par exemple un capteur triaxe dont les axes de mesure sont solidaires de l'objet 4. Ce capteur 40 est ici identique au capteur 20.

Les capteurs 20 et 40 et la source 10 sont raccordés à une unité 42 de traitement. Cette unité 42 acquiert les mesures réalisées par les capteurs 20 et 40 et alimentent également la source 10 pour émettre le champ magnétique. Typiquement, l'unité 42 alimente la source 10 en courant alternatif pour générer le champ magnétique.

Plus précisément, l'unité 42 mesure sur chaque axe de mesure de chaque capteur l'amplitude des composantes du champ magnétique en quadrature de phase et en phase avec le champ magnétique émis. A cet effet, l'unité 42 est un détecteur synchrone. Un exemple d'un tel détecteur synchrone est décrit en regard de la figure 16 du brevet US 6 528 989. Ainsi, l'unité 42 ne sera pas décrite ici plus en détail.

L'unité 42 est raccordée à un module 44 de localisation de l'objet 4 dans le référentiel 6. Typiquement, ce module 44 détermine la position et l'orientation de l'objet 4 en résolvant un système d'équations. Ce système d'équations est obtenu en modélisation les interactions magnétiques entre la source monoaxe et les différents transducteurs monoaxes composants les capteurs sans tenir compte de la présence d'un perturbateur magnétique. Dans ce système d'équations, la position x, y et z et l'orientation $\theta_x$, $\theta_y$ et $\theta_z$ de l'objet 4 sont des inconnues alors que les valeurs des autres paramètres sont obtenues à partir des mesures réalisées par le capteur 40. Plus d'informations sur de tels systèmes d'équations peuvent, par exemple, être trouvés dans la demande de brevet EP 1 502 544.

Ici, de préférence, ce système d'équations s'écrit sous la forme d'un filtre de Kalman.

Dans ce mode de réalisation, le module 44 comprend un compensateur 46 des mesures du champ magnétique. Ce compensateur 46 corrige les mesures du champ magnétique afin de réduire les conséquences des perturbations de ces mesures causées par un perturbateur magnétique. Les mesures ainsi compensées sont alors utilisées pour localiser l'objet 4.

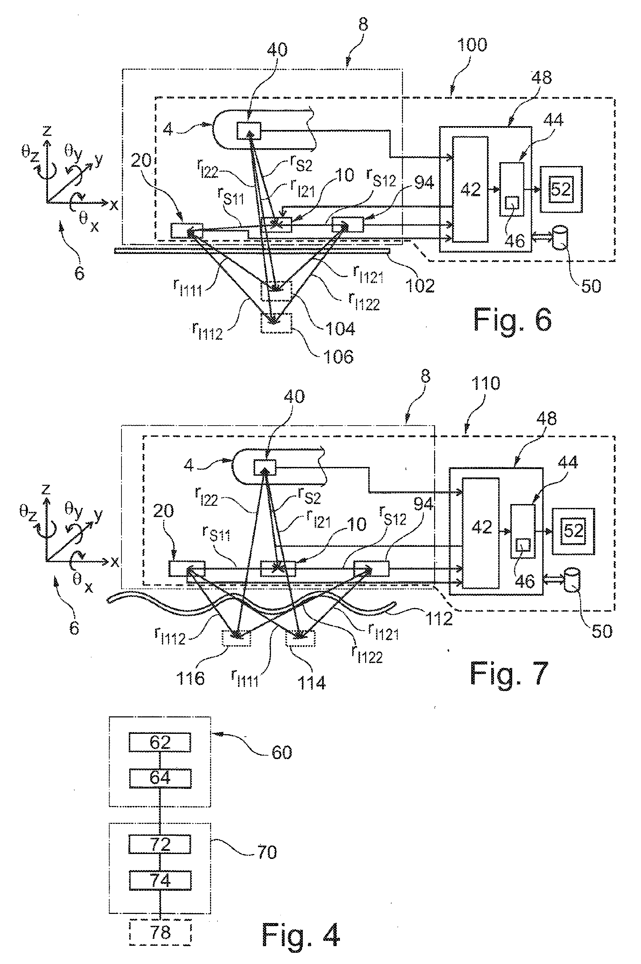

Par exemple, l'unité 42 se présente sous la forme d'une carte électronique tandis que le module 44 se présente sous la forme d'un module logiciel. Le système 2 comprend donc un calculateur électronique programmable 48 incorporant l'unité 42 et apte à exécuter des instructions enregistrées sur un support d'enregistrement d'informations. Le calculateur 48 est raccordé à une mémoire 50 contenant les instructions pour l'exécution du procédé de la figure 4 lorsqu'elles sont exécutées par le calculateur 48. Le calculateur 48 est également raccordé à une interface homme-machine 52. Par exemple, l'interface homme-machine comprend un écran sur lequel est présenté la position de l'objet 4 dans le référentiel 6.

La source 10, le capteur 20 et le compensateur 46 forme un dispositif de compensation des mesures du capteur 40.

Enfin, sur la figure 1, un perturbateur magnétique 54 a été représenté. Ce perturbateur 54 est fixe par rapport à la source 10. Dans le cas présent, il présente une face plane horizontale c'est- à- dire parallèle au plan défini par les axes X et Y du référentiel 6. Plus précisément, ce perturbateur 54 se présente ici sous la forme d'une plaque rectangulaire de longueur $L_x$ et de largeur $l_y$. Ces dimensions $L_x$ et $l_y$ sont suffisamment grandes pour que la distance $r_{s2}$ entre la source 10 et le capteur 40 soit inférieure au quart de la plus petite de ces dimensions $L_x$ et $l_y$. Dans ces conditions, le perturbateur 54 est considéré comme un plan infini vis- à- vis des mesures réalisées par le capteur 40 et le capteur 20.

De plus, dans ce premier mode de réalisation, on suppose que le perturbateur 54 est très fortement conducteur, c'est-à-dire qu'il présente une conductivité supérieure à 10 S.m$^{-1}$ et, de préférence, supérieure à 40 ou 50 S.m$^{-1}$. Par exemple, le perturbateur 54 est une plaque d'aluminium. Ici, ce perturbateur 54 est une table d'opération.

Le fonctionnement du système 2 va maintenant être décrit en regard du procédé de la figure 4.

Le procédé débute par une phase 60 de calibration. Lors de cette phase 60 et plus précisément lors d'une étape 62, la source 10 émet un champ magnétique et le capteur 20 mesure ce champ magnétique.

Ensuite, ces mesures sont acquises par l'unité 42 et transmises au compensateur 46. Le compensateur 46 procède alors à une étape 64 de détermination de la position et du moment magnétique d'une image 66 de la source 10 par rapport au perturbateur 54.

Une image d'une source monoaxe est une source théorique de champ magnétique fictif située de l'autre côté du perturbateur magnétique. La composante du champ magnétique fictif normale à la face du perturbateur est conservée au passage de cette face. Par « conservé », on signifie que la composante normale est identique des deux côtés de la face traversée. De plus, la position et l'intensité du moment magnétique de l'image sont telles qu'ils minimisent la relation suivante :

$$B_{me} - (B_s + B_l),$$

où :

- $B_{me}$ est le champ magnétique mesuré par le capteur 20 en présence du perturbateur magnétique 54,
- Bs est le champ magnétique émis par la source 10 mesurable par le capteur 20 en absence du perturbateur magnétique 54, et
- $B_l$ est le champ magnétique fictif émis par l'image 66 qui serait mesuré par le capteur 20 en absence du perturbateur magnétique.

Lors de cette étape 64, en utilisant les équations de l'électromagnétisme, la position et le moment $M_l$ de l'image 66 sont déterminés. Pour simplifier les calculs, on utilise également ici l'approximation dipolaire. Dans ces conditions, le champ magnétique produit par la source 10 et son image 66 en absence du perturbateur 54 et mesuré par le capteur 20 est donné par la relation suivante

$$(1) \qquad \vec{B}\_mo1 = \frac{\mu_0}{4\pi}\left[\frac{3\left(\vec{M}_S \vec{r}_{SI}\right)\vec{r}_{SI}}{r_{SI}^5} - \frac{\vec{M}_S}{r_{SI}^3}\right] + \frac{\mu_0}{4\pi}\left[\frac{3\left(\vec{M}_I \vec{r}_{II}\right)\vec{r}_{II}}{r_{II}^5} - \frac{\vec{M}_I}{r_{II}^3}\right]$$

où :

- $\overleftrightarrow{B}\_mo1$ est le champ magnétique produit par la source 10 et son image 66 qui serait mesuré par le capteur 20 en absence du perturbateur magnétique 54,
- $\mu_0$ est la perméabilité du vide,
- $\overleftrightarrow{M}_s$ est le moment magnétique de la source 10,
- $r_{S1}$ est la distance qui sépare le centre $O_s$ du centre $O_{c1}$ du capteur 20,
- $\overleftrightarrow{M}_l$ est le moment magnétique de l'image 66,
- $r_{l1}$ est la distance qui sépare le centre de l'image 66 du centre du capteur 20.

La distance $\overleftrightarrow{r}_{l1}$ est fonction des coordonnées $x_l$, $y_l$ et $z_l$ de l'image 66 dans le repère 6. Dans le cas particulier décrit ici où le moment magnétique $\overleftrightarrow{M}_S$ est perpendiculaire au plan dans lequel s'étend essentiellement le perturbateur 54, le moment magnétique $\overleftrightarrow{M}_l$ est nécessairement parallèle au moment magnétique $\overleftrightarrow{M}_S$ d'après la théorie des images en électromagnétisme. Une telle hypothèse est également vraie lorsque le moment magnétique $M_S$ est parallèle au plan dans lequel s'étend essentiellement le perturbateur 54. Plus d'informations sur cette théorie des images peuvent être trouvées dans les documents suivants :

- « Exact image Theory for the Sommerfield Half-space problem, part I : Vertical Magnetic Dipole », I. Lindell, IEEE Transactions on Antennas and Propagation, vol. AP-32, NO.2, février 1984,
- « Exact Image Theory for the Sommerfield Half-space problem, part 111: General Formulation », I. Lindell, IEEE Transactions on Antennas and propagation, vol. AP-32, N°10, octobre 1984.

La relation (1) comporte donc quatre inconnues, à savoir $x_l$, $y_l$ et $z_l$ ainsi que l'amplitude du moment magnétique $M_l$. Par ailleurs, la relation (1) qui est exprimée sous forme vectorielle correspond à trois équations. Ainsi, pour pouvoir déterminer le moment $M_l$ et la position de l'image 66, une contrainte supplémentaire doit être imposée. Dans le cas particulier de la figure 1, étant donné que les dimensions du perturbateur 54 sont bien plus grandes que les distances $r_{s1}$ et $r_{s2}$ qui séparent la source 1, respectivement, des capteurs 20 et 40, on suppose ici que le perturbateur 54 est un plan conducteur infiniment grand. Dans ces conditions, d'après la théorie des images en électromagnétisme, la distance qui sépare l'image 66 de ce plan infiniment grand est égale à la distance qui sépare la source 10 de ce même plan. Ainsi, on dispose donc d'un système d'équations à trois équations et à trois inconnues. Ici, ce système d'équations est résolu en déterminant la position et le moment magnétique de l'image 66 qui minimise le critère suivant :

$$(2) \qquad Min\left[\vec{B}\_me1 - \vec{B}\_mo1\right]$$

où :

- $\overset{\leftrightarrow}{\underset{}{B}}\_me1$ est le champ magnétique mesuré par le capteur 20, et
- $B\_mo1$ est le champ magnétique émis par la source 10 et son image 66 telle que défini par la relation (1).

La recherche de la solution optimale qui minimise le critère (2) est réalisée à l'aide d'une routine connue d'optimisation telle que celles disponibles dans l'application logicielle Matlab®.

Une fois la position et le moment magnétique de l'image 66 déterminés, on procède à une phase 70 de localisation de l'objet 4 dans le référentiel 6.

Cette phase 70 débute par une étape 72 lors de laquelle la source 10 émet un champ magnétique et le capteur 40 mesure ce champ magnétique émis. Les mesures du capteur 40 sont acquises par l'unité 42 et transmises au module 44 et au compensateur 46.

Ensuite, lors d'une étape 74, la position de l'objet 4 est déterminée à partir des mesures compensées par le compensateur 46. Ici, la mesure compensée correspond au champ magnétique mesuré par le capteur 40 moins le champ magnétique généré par l'image 66.

Dans ce mode de réalisation, étant donné que la position de l'objet 4 dans le référentiel 6 est inconnue, la localisation de l'objet 4 et la compensation des mesures du capteur 40 sont réalisées en même temps.

A cet effet, lors de l'étape 74, la position du capteur 40 qui minimise le critère suivant est déterminée :

$$(3) \quad Min\left[\vec{B}\_me2 - \vec{B}\_mo2\right]$$

où :

- $\overset{\leftrightarrow}{\underset{}{B}}\_me2$ est le champ magnétique mesuré par le capteur 40, et
- $B\_mo2$ est le champ magnétique émis par la source 10 et son image 66 en absence du perturbateur 54.

D'après les équations de l'électromagnétisme et en utilisant l'approximation dipolaire, le champ magnétique $B\_mo2$ est donné par la relation suivante :

$$(4) \quad \vec{B}\_mo2 = \frac{\mu_0}{4\pi}\left[\frac{3\left(\vec{M}_S\vec{r}_{S2}\right)\vec{r}_{S2}}{r_{S2}^5} - \frac{\vec{M}_S}{r_{S2}^3}\right] + \frac{\mu_0}{4\pi}\left[\frac{3\left(\vec{M}_I\vec{r}_{I2}\right)\vec{r}_{I2}}{r_{I2}^5} - \frac{\vec{M}_I}{r_{I2}^3}\right]$$

où :

- $r_{s2}$ est la distance qui sépare le centre de la source 10 du centre du capteur 40, et
- $r_{I2}$ est la distance qui sépare le centre de l'image 66 du capteur 40.

Ces différentes distances ont été représentées sur la figure 1.

Le deuxième terme de la relation (4) correspond aux champs magnétiques émis par l'image 66 mesurables par le capteur 40. Ce deuxième terme est soustrait à la mesure du champ $\overset{\leftrightarrow}{B}\_me2$ dans le critère (3) de sorte que c'est bien la mesure compensée du champ magnétique qui est utilisée pour localiser l'objet 4.

Lors de l'étape 74, les inconnues du système d'équations sont les distances $r_{S2}$ et $r_{I2}$. Une fois ce système d'équations résolu, la position de l'objet 4 est connue.

Eventuellement, après la phase 70, lors d'une étape 78, la mesure compensée du champ magnétique mesuré par le capteur 40 peut être exprimée en soustrayant au champ magnétique mesuré $\overset{\leftrightarrow}{B}\_me2$ la valeur du champ magnétique émis au même instant par l'image 66.

La figure 5 représente un système 90 de localisation de l'objet 4 utilisable même dans le cas où le perturbateur magnétique n'est pas assimilable à un plan conducteur infini. Par exemple, dans ce mode de réalisation, le perturbateur 54 est remplacé par un perturbateur 92 qui n'est pas fortement conducteur ou dont la taille n'est pas suffisamment grande pour que sa face plane supérieure puisse être assimilée à un plan infiniment conducteur. Par exemple, sur la figure 5, le perturbateur 92 représenté est trop petit pour être assimilé à un plan infini. Par conséquent, dans ce cas là, le nombre d'inconnues du système d'équations est supérieur au nombre d'équations de sorte que, lors de l'étape 64, il n'est pas possible de déterminer précisément la position d'une image de la source à l'aide des mesures du seul capteur 20. Pour résoudre ce problème, le système 90 est identique au système 2 à l'exception du fait qu'il comporte en plus un capteur 94 dont la position par rapport à la source 10 est connue. Par exemple, ce capteur 94 est fixe par rapport à la source 10.

Le fonctionnement de ce système 90 est identique à celui du système 2 à l'exception du fait que lors de l'étape 64 la détermination de la position et du moment magnétique de l'image 66 est réalisée à partir des mesures des capteurs 20 et 94. A cet effet, par exemple, le champ magnétique généré par la source 10 et son image 66 en absence du perturbateur 92 est modélisé à l'aide des équations suivantes :

$$(5) \qquad \vec{B}\_\mathrm{mo11} = \frac{\mu_0}{4\pi}\left[\frac{3\left(\vec{M}_S \vec{r}_{SI1}\right)\vec{r}_{SI1}}{r_{SI1}^5} - \frac{\vec{M}_S}{r_{SI1}^3}\right] + \frac{\mu_0}{4\pi}\left[\frac{3\left(\vec{M}_I \vec{r}_{II1}\right)\vec{r}_{II1}}{r_{II1}^5} - \frac{\vec{M}_I}{r_{II1}^3}\right]$$

$$(6) \qquad \vec{B}\_\mathrm{mo12} = \frac{\mu_0}{4\pi}\left[\frac{3\left(\vec{M}_S \vec{r}_{SI2}\right)\vec{r}_{SI2}}{r_{SI2}^5} - \frac{\vec{M}_S}{r_{SI2}^3}\right] + \frac{\mu_0}{4\pi}\left[\frac{3\left(\vec{M}_I \vec{r}_{II2}\right)\vec{r}_{II2}}{r_{II2}^5} - \frac{\vec{M}_I}{r_{II2}^3}\right]$$

où :

- $\overset{\leftrightarrow}{B}$\_mo11 est le champ magnétique émis par la source 10 et l'image 66 qui serait mesuré par le capteur 20 en absence du perturbateur 92,
- $\overset{\leftrightarrow}{B}$\_mo12 est le champ magnétique émis par la source 10 et son image 66 qui serait mesuré par le capteur 94 en absence du perturbateur,
- $\overset{\leftrightarrow}{r}_{S11}$ et $\overset{\leftrightarrow}{r}_{S12}$ sont les distances qui séparent la source 10, respectivement, des capteurs 20 et 94, et
- $r_{I11}$ et $r_{I12}$ sont les distances qui séparent l'image 66, respectivement, des capteurs 20 et 94.

Ensuite, la position de l'image et le moment magnétique $M_I$ de l'image 66 sont déterminés de manière à minimiser les critères suivants :

$$(7) \qquad Min\left[\vec{B}\_me11 - \vec{B}\_\mathrm{mo11}\right]$$

$$(8) \qquad Min\left[\vec{B}\_me12 - \vec{B}\_\mathrm{mo12}\right]$$

où :

- $\overset{\leftrightarrow}{B}$\_me11 et $\overset{\leftrightarrow}{B}$\_me12 sont les mesures du champ magnétique réalisées, respectivement, par les capteurs 20 et 94.

Le système d'équations à résoudre comporte dont six équations et quatre inconnues. Il est donc possible de déterminer précisément la position de l'image 66 qui minimise les critères (7) et (8) ci-dessus.

Une fois cette étape terminée, la phase de localisation de l'objet 4 dans le référentiel 6 se déroule exactement comme décrit en regard de la figure 4.

La figure 6 représente un système 100 de localisation de l'objet 4 spécialement adapté au cas où les mesures sont perturbées par un perturbateur magnétique 102 à la fois fortement conducteur et perméable. Par exemple, ici, le perturbateur 102 est une plaque réalisée en acier inoxydable magnétique. Les dimensions de cette plaque sont par exemple identiques à celles de la plaque 54 décrite en regard de la figure 1.

Pour améliorer la compensation de la mesure dans ce cas, deux images de la source 10 sont construites. Tout d'abord, une image 104 appelée par la suite « image conductrice » qui correspond au cas où le perturbateur 102 serait remplacé par un perturbateur de même dimension et réalisé dans un matériau ayant exactement la même conductivité mais imperméable. Par imperméable on désigne le fait que la perméabilité relative est égale à un.

Une autre image 106 de la source 10, appelée ci-dessous « image magnétique » est également construite. Cette image 106 correspond au cas où le perturbateur 102 serait remplacé par un perturbateur magnétique ayant exactement les mêmes dimensions et réalisé dans un matériau ayant la même perméabilité mais non conducteur.

Pour simplifier la figure 6, les images 104 et 106 sont représentées l'une en dessous de l'autre.

Le système 100 est identique au système 90 à l'exception du fait qu'il comporte les instructions nécessaires pour calculer les positions et les moments magnétiques des images 104 et 106. A cet effet, le système 100 exploite le fait qu'un perturbateur fortement conducteur et non perméable perturbe essentiellement les mesures en quadrature de phase du champ magnétique. A l'inverse, un perturbateur perméable et non conducteur perturbe essentiellement les mesures en phase du champ magnétique.

Le fonctionnement du système 100 est donc identique à celui décrit en regard de la figure 4 à l'exception du fait que lors de l'étape 64 la position et les moments magnétiques des images 104 et 106 sont déterminés à l'aide des relations suivantes :

(9)

$$\vec{B}\_\text{mo11}\_Q = \frac{\mu_0}{4\pi}\left[\frac{3\left(\vec{M}_S \vec{r}_{S11}\right)\vec{r}_{S11}}{r_{S11}^5} - \frac{\vec{M}_S}{r_{S11}^3}\right] + \frac{\mu_0}{4\pi}\left[\frac{3\left(\vec{M}_{I1}\vec{r}_{I111}\right)\vec{r}_{I111}}{r_{I111}^5} - \frac{\vec{M}_{I1}}{r_{I111}^3}\right]$$

(10)

$$\vec{B}\_\text{mo11}\_I = \frac{\mu_0}{4\pi}\left[\frac{3\left(\vec{M}_S \vec{r}_{S11}\right)\vec{r}_{S11}}{r_{S11}^5} - \frac{\vec{M}_S}{r_{S11}^3}\right] + \frac{\mu_0}{4\pi}\left[\frac{3\left(\vec{M}_{I2}\vec{r}_{I112}\right)\vec{r}_{I112}}{r_{I112}^5} - \frac{\vec{M}_{I2}}{r_{I112}^3}\right]$$

(11)

$$\vec{B}\_\text{mo12}\_Q = \frac{\mu_0}{4\pi}\left[\frac{3\left(\vec{M}_S \vec{r}_{S12}\right)\vec{r}_{S12}}{r_{S12}^5} - \frac{\vec{M}_S}{r_{S12}^3}\right] + \frac{\mu_0}{4\pi}\left[\frac{3\left(\vec{M}_{I1}\vec{r}_{I121}\right)\vec{r}_{I121}}{r_{I121}^5} - \frac{\vec{M}_{I1}}{r_{I121}^3}\right]$$

(12)

$$\vec{B}\_\text{mo12}\_I = \frac{\mu_0}{4\pi}\left[\frac{3\left(\vec{M}_S \vec{r}_{S12}\right)\vec{r}_{S12}}{r_{S12}^5} - \frac{\vec{M}_S}{r_{S12}^3}\right] + \frac{\mu_0}{4\pi}\left[\frac{3\left(\vec{M}_{I2}\vec{r}_{I122}\right)\vec{r}_{I122}}{r_{I122}^5} - \frac{\vec{M}_{I2}}{r_{I122}^3}\right]$$

où :

- $\vec{B}$_mo11_Q est le champ magnétique en quadrature de phase avec le champ émis par la source 10 et l'image 104 qui serait mesuré par le capteur 20 en absence du perturbateur 102,
- $\vec{B}$_mo11_I est le champ magnétique en phase avec le champ magnétique émis par la source 10 et l'image 106 qui serait mesuré par le capteur 20 en absence du perturbateur 102,
- $\vec{B}$_mo12_Q est le champ magnétique en quadrature de phase émis par la source 10 et l'image 104 qui serait mesuré par le capteur 94 en absence du perturbateur 102,
- $\vec{B}$_mo12_I est le champ magnétique en phase avec le champ magnétique émis par la source 10 et l'image 106 qui serait mesuré par le capteur 94 en absence du perturbateur 102,
- $r_{s11}$, $r_{I111}$ et $r_{I112}$ sont les distances qui séparent le capteur 20, respectivement, de la source 10 et des images 104 et 106,
- $\vec{M}_{I1}$ et $\vec{M}_{I2}$ sont les moments magnétiques, respectivement, des images 104 et 106,
- $r_{S12}$, $r_{I121}$ et $r_{I122}$ sont les distances qui séparent le capteur 94, respectivement, de la source 10 et des images 104 et 106.

Lors de l'étape 64, la position et les moments magnétiques des images 104 et 106 sont déterminés en recherchant le minimum des critères suivants :

$$(13) \quad Min\left[\overleftrightarrow{B}\_me11\_Q - \overrightarrow{B}\_mo11\_Q\right]$$

$$(14) \quad Min\left[\overleftrightarrow{B}\_me11\_I - \overrightarrow{B}\_mo11\_I\right]$$

$$(15) \quad Min\left[\overleftrightarrow{B}\_me12\_Q - \overrightarrow{B}\_mo12\_Q\right]$$

$$(16) \quad Min\left[\overleftrightarrow{B}\_me12\_I - \overrightarrow{B}\_mo12\_I\right]$$

où :

- $\overleftrightarrow{B}\_me11\_Q$ et $\overleftrightarrow{B}\_me11\_I$ sont les mesures par le capteur 20, respectivement en quadrature et en phase, du champ magnétique émis par la source 10 en présence du perturbateur 102, et
- $\overleftrightarrow{B}\_me12\_Q$ et $\overleftrightarrow{B}\_me12\_I$ sont les mesures réalisées par le capteur 94, respectivement en quadrature de phase et en phase, du champ magnétique émis par la source 10 en présence du perturbateur 102.

Les équations précédentes correspondent à un système à douze équations et à huit inconnues ce qui permet donc de déterminer précisément les positions et les moments magnétiques des images 104 et 106.

Ensuite, lors de la phase de la localisation et plus précisément lors de l'étape 74, la position de l'objet 4 est déterminée à l'aide de la relation (17) suivante :

$$\vec{B}\_mo2 = \frac{\mu_0}{4\pi}\left[\frac{3\left(\vec{M}_S \vec{r}_{S2}\right)\vec{r}_{S2}}{r_{S2}^5} - \frac{\vec{M}_S}{r_{S2}^3}\right] + \frac{\mu_0}{4\pi}\left[\frac{3\left(\vec{M}_{I1} \vec{r}_{I21}\right)\vec{r}_{I21}}{r_{I21}^5} - \frac{\vec{M}_{I1}}{r_{I21}^3}\right] + \frac{\mu_0}{4\pi}\left[\frac{3\left(\vec{M}_{I2} \vec{r}_{I22}\right)\vec{r}_{I22}}{r_{I22}^5} - \frac{\vec{M}_{I2}}{r_{I22}^3}\right]$$

où :

- $\overleftrightarrow{B}\_mo2$ est le champ magnétique émis par les sources 10 et les images 104 et 106 qui serait mesuré par le capteur 40 en absence du perturbateur magnétique 102,
- $\vec{r}_{S2}$, $\vec{r}_{I21}$ et $\vec{r}_{I22}$ sont les distances qui séparent le capteur 40, respectivement, de la source 10 et des images 104 et 106.

La position du capteur 40 est alors déterminée lors de l'étape 74 en trouvant le minimum du critère suivant :

$$(18) \quad Min\left[\vec{B}\_me2 - \vec{B}\_mo2\right]$$

où $\overleftrightarrow{B}\_me2$ est le champ magnétique mesuré par le capteur 40 en présence du perturbateur magnétique 102.

Ce critère (18) correspond à un système à trois équations et à trois inconnues c'est-à-dire les distances $r_{S2}$, $r_{I21}$ et $r_{I22}$. Le minimum de cette relation fournit la position du capteur 40 dans le repère 6.

La figure 7 représente un autre système 110 de localisation de l'objet 4 spécialement adapté au cas où les mesures des champs magnétiques sont perturbées par un perturbateur magnétique 112 qui présente des propriétés magnétiques ou qui a une forme plus éloignés de celles utilisées dans la théorie des images. Dans ce cas, le système 110 comporte des instructions telles que plusieurs images de la source 10 par rapport au perturbateur 112 sont construites. Par exemple, ici, deux images de la source 10, respectivement, 114 et 116 sont utilisées. A cet effet, le système 110 est identique au système 90 à l'exception qu'il comporte des instructions pour déterminer les positions et les moments magnétiques des images 114 et 116.

Plus précisément, le fonctionnement du système 110 est identique à celui du système 90 sauf que les étapes 64 et 74 sont adaptées, d'une part, pour déterminer les positions et les moments magnétiques des images 114 et 116 et d'autre part pour utiliser le champ magnétique émis par ces images 114 et 116 pour compenser les mesures du capteur 40.

Par exemple, lors de l'étape 64, les relations suivantes sont utilisées :

(19)

$$\vec{B}\_\text{mo}11 = \frac{\mu_0}{4\pi}\left[\frac{3\left(\vec{M}_S\vec{r}_{SI1}\right)\vec{r}_{SI1}}{r_{SI1}^5} - \frac{\vec{M}_S}{r_{SI1}^3}\right] + \frac{\mu_0}{4\pi}\left[\frac{3\left(\vec{M}_{I1}\vec{r}_{I1I1}\right)\vec{r}_{I1I1}}{r_{I1I1}^5} - \frac{\vec{M}_{I1}}{r_{I1I1}^3}\right]$$

(20)

$$\vec{B}\_\text{mo}12 = \frac{\mu_0}{4\pi}\left[\frac{3\left(\vec{M}_S\vec{r}_{SI2}\right)\vec{r}_{SI2}}{r_{SI2}^5} - \frac{\vec{M}_S}{r_{SI2}^3}\right] + \frac{\mu_0}{4\pi}\left[\frac{3\left(\vec{M}_{I2}\vec{r}_{I1I21}\right)\vec{r}_{I122}}{r_{I122}^5} - \frac{\vec{M}_{I2}}{r_{I122}^3}\right]$$

où:

- $\overleftrightarrow{B}$_mo11 est le champ magnétique émis par la source 10 et l'image 114 mesurable par le capteur 20,
- $\overleftrightarrow{B}$_mo12 est le champ magnétique émis par la source 10 et l'image 116 mesurable par le capteur 94 en absence du perturbateur 112,
- $\overleftrightarrow{r}_{S11}$ et $\overleftrightarrow{r}_{I111}$ sont les distances qui séparent le capteur 20, respectivement, de la source 10 et de l'image 114,
- $\overleftrightarrow{r}_{S12}$ et $\overleftrightarrow{r}_{I122}$ sont les distances qui séparent le capteur 94, respectivement, de la source 10 et de l'image 116, et
- $M_{I1}$ et $M_{I2}$ sont les moments, respectivement, des images 114 et 116.

Ensuite, la position et les moments magnétiques des images 114 et 116 sont déterminés en trouvant l'optimum des critères suivants :

$$(21)\quad Min\left[\vec{B}\_me11 - \vec{B}\_\text{mo}11\right]$$

$$(22)\quad Min\left[\vec{B}\_me12 - \vec{B}\_\text{mo}12\right]$$

où :

- $\overleftrightarrow{B}$_me11 et $\overleftrightarrow{B}$_me12 sont les mesures du champ magnétique émis par la source 10 réalisées, respectivement, par les capteurs 20 et 94.

Ces critères (21) et (22) correspondent à un système à six équations et à huit inconnues. Ainsi, pour trouver le minimum, deux contraintes supplémentaires sur la position ou le moment magnétique des images 114 et 116 sont imposés. Ces contraintes supplémentaires sont issues de la théorie des images en électromagnétisme. Par exemple, dans ce cas, on suppose que la conductivité σ et la perméabilité relative $\mu_r$ du perturbateur 112 sont connues. Dans ces conditions, les moments magnétiques $M_{I1}$ et $M_{I2}$ peuvent être calculés à l'aide de la relation suivante :

$$M_i = M_S\left(\frac{1-\mu_r}{1+\mu_r}\right)\left(\frac{1-\sigma}{1+\sigma}\right)$$

(24)

où $M_i$ est le moment magnétique de l'image 114 ou 116.

Ensuite, lors de l'étape 74, la position du capteur 40 est déterminée à l'aide de l'équation (23) suivante :

$$\vec{B}\_\text{mo}2 = \frac{\mu_0}{4\pi}\left[\frac{3\left(\vec{M}_S\vec{r}_{S2}\right)\vec{r}_{S2}}{r_{S2}^5} - \frac{\vec{M}_S}{r_{S2}^3}\right] + \frac{\mu_0}{4\pi}\left[\frac{3\left(\vec{M}_{I1}\vec{r}_{I121}\right)\vec{r}_{I121}}{r_{I121}^5} - \frac{\vec{M}_{I1}}{r_{I121}^3}\right] + \frac{\mu_0}{4\pi}\left[\frac{3\left(\vec{M}_{I2}\vec{r}_{I122}\right)\vec{r}_{I122}}{r_{I122}^5} - \frac{\vec{M}_{I2}}{r_{I122}^3}\right]$$

où :

- $r_{s2}$, $r_{l21}$ et $r_{l22}$ sont les distances qui séparent le capteur 40, respectivement, de la source 10, de l'image 114 et de l'image 116, et
- $\overline{B}\_mo2$ est le champ magnétique émis par la source 10 et les images 114 et 116 et mesurable par le capteur 40 en absence du perturbateur magnétique 112.

La position du capteur 40 est alors déterminée en trouvant le minimum du critère suivant :

$$(25) \quad Min\left[\vec{B}\_me2 - \vec{B}\_mo2\right]$$

où $\overleftrightarrow{B}\_me2$ est le champ magnétique mesuré par le capteur 40 en présence du perturbateur 112.

Le critère ci-dessus correspond à un système à trois équations et à trois inconnues qui permet donc d'obtenir la position du capteur 40 dans le repère 6.

De nombreux autres modes de réalisation sont possibles. Par exemple, il n'est pas nécessaire que la source 10 soit fixe dans le repère 6. En variante, la source 10 peut se déplacer de façon connue dans le repère 6.

Il n'est pas non plus nécessaire que le capteur 20 et le capteur 40 soit deux capteurs magnétiques distincts. Par exemple, en variante, le capteur 20 est positionné à un emplacement prédéterminé connu lors de la phase de calibration puis ensuite fixé à l'objet 4 lors de la phase de localisation de cet objet.

Le nombre de capteurs et/ou le nombre d'axes de mesure de ces capteurs peut être modifié. Dans tous les cas ce nombre doit être suffisant pour permettre la détermination précise de la position et du moment magnétique d'au moins une image de la source et la localisation de l'objet 4.

Pour déterminer la position des images de la source 10, d'autres contraintes issues de la théorie des images en électromagnétisme peuvent être utilisées pour limiter le nombre de capteurs ou le nombre d'axe des capteurs utilisés. Par exemple, si la conductivité $\sigma$ et la perméabilité relative $\mu_r$ du perturbateur sont connues, alors la relation suivante peut être utilisée :

$$(26) \qquad M_i = M_S\left(\frac{1-\mu_r}{1+\mu_r}\right)\left(\frac{1-\sigma}{1+\sigma}\right)$$

où Mi est le moment magnétique de l'image.

Dans le cas où le perturbateur est uniquement perméable ou uniquement conducteur, la loi de conservation de la composante normale du champ magnétique à la traversée de la face plane du perturbateur permet de déterminer l'orientation du moment de la source de l'image.

Le nombre d'axes de la source 10 ou des capteurs peut être modifié. Toutefois, ce nombre d'axes doit rester suffisant pour permettre la détermination de la position et du moment magnétique de l'image ainsi que la localisation de l'objet 4.

Ici, le système de localisation et en particulier la compensation de la mesure a été décrit dans le cas où le champ magnétique qui serait mesuré en absence du perturbateur magnétique est calculé à partir des équations de l'électromagnétisme. Toutefois, dans une autre variante, ce champ magnétique est mesuré. Pour cela, le champ magnétique de la source 10 est mesuré par le capteur 20 et/ou le capteur 94 en absence du perturbateur magnétique. Ensuite, la position et le moment magnétique de l'image de la source 10 par rapport à ce perturbateur magnétique sont calculés de manière à ce que le champ magnétique produit par cette image minimise la relation suivante :

$$(27) \quad \vec{B}_{me} - \vec{B}_S - \vec{B}_i$$

où :

- $\overleftrightarrow{B}_{me}$ et $\overleftrightarrow{B}_S$ sont les champs magnétiques mesurés, respectivement, en présence et en absence du perturbateur magnétique, et
- le champ $\vec{B}_i$ est le champ magnétique généré par l'image de la sonde 10 dont la position et le moment magnétique sont à déterminer.

Le système 100 exploite la théorie selon laquelle :

- un perturbateur fortement conducteur et non perméable perturbe essentiellement les mesures en quadrature de phase du champ magnétique, et
- un perturbateur perméable et non conducteur perturbe essentiellement les mesures en phase du champ magnétique.

Il arrive dans la réalité que cette théorie ne soit pas parfaite. Dans ce cas, pour améliorer la compensation, il est possible de s'intéresser au module efficace du champ magnétique. Le module efficace A du champ magnétique est défini par la relation suivante : $A = \sqrt{I^2 + Q^2}$ , où :

- A est le module efficace du champ magnétique mesuré,
- I est l'amplitude du champ magnétique mesuré en phase avec le champ magnétique émis par la source 10, et
- Q est l'amplitude du champ magnétique mesuré en quadrature de phase avec le champ magnétique émis par la source 10.

Dans ce cas, le fonctionnement du système 100 est identique à celui décrit en regard de la figure 6 sauf que lors de l'étape 64, on calcule les modules efficaces A_mo11 et A_mo12, par exemple, à l'aide des relations suivantes :

$$(28) \qquad A\_mo11 = \sqrt{B\_mo11\_Q^2 + B\_mo11\_I^2}$$

$$(29) \qquad A\_mo12 = \sqrt{B\_mo12\_Q^2 + B\_mo12\_I^2}$$

où :

- $A\_mo11$ et $A\_mo12$ sont les modules efficaces du champ magnétique émis par la source 10 et les images 104 et 106 qui seraient mesurés, respectivement, par les capteurs 20 et 94 en absence du perturbateur 102,
- $B\_mo11\_Q$ et $B\_mo12\_Q$ sont les amplitudes du champ magnétique en quadrature de phase émis par la source 10 et les images 104 et 106 qui seraient mesurées par le capteur 20 en absence du perturbateur 102, et
- $B\_mo11\_I$ et $B\_mo12\_I$ sont les amplitudes du champ magnétique en phase émis par la source 10 et les images 104 et 106 qui seraient mesurées par le capteur 94 en absence du perturbateur 102.

Par exemple, les amplitudes $B\_mo11\_Q$ , $B\_mo11\_I$ , $B\_mo12\_Q$ et $B\_mo12\_I$ sont déterminées à partir des relations (9) à (12) précédemment décrites.

La position des images 104 et 106 est ensuite déterminée en minimisant les critères suivants :

$$(30) \quad Min\lfloor A\_me11 - A\_mo11 \rfloor$$

$$(31) \quad Min\lfloor A\_me12 - A\_mo12 \rfloor$$

où $A\_me11$ et $A\_me12$ sont les modules efficaces des champs magnétiques mesurés, respectivement, par les capteurs 20 et 94.

Pour augmenter le nombre d'équations et permettre une détermination plus précise des positions et moments magnétiques des images 104 et 106, on peut aussi utiliser les deux relations suivantes :

$$(30)$$

$$M_{II} = M_S \left( \frac{1 - \mu_r}{1 + \mu_r} \right)$$

(31)

$$M_{I2} = M_S \left( \frac{1-\sigma}{1+\sigma} \right)$$

La conductivité $\sigma$ et la perméabilité relative $\mu_r$ du perturbateur 102 peuvent être connues ou inconnues. Dans ce dernier cas elles seront déterminées.

Le module efficace peut également être utilisé pour déterminer la position et le moment magnétique d'une seule image de la source 10. Dans ce cas, les relations données ci-dessus sont simplifiées.

Dans le cas où il n'est pas nécessaire de recourir au module efficace du champ magnétique pour déterminer la position d'une ou des images et si le perturbateur magnétique est uniquement conducteur et non perméable, alors il est possible d'utiliser uniquement les mesures en quadrature de phase du champ magnétique au lieu de l'amplitude efficace de ce champ magnétique. A l'inverse, si le perturbateur magnétique est uniquement perméable et non conducteur, alors il est possible d'utiliser uniquement les mesures en phase du champ magnétique au lieu de l'amplitude efficace de ce champ magnétique.

La compensation de la mesure a été décrite ici dans le cas particulier où la mesure compensée est utilisée pour améliorer la précision de la localisation d'un objet. Toutefois, en variante, le procédé de compensation est utilisé dans d'autre application. Par exemple, le procédé de compensation décrit peut être utilisé pour compenser la mesure d'un capteur dont la position est connue.

**Revendications**

1. Procédé de compensation d'une mesure d'un champ magnétique, ce procédé comportant :

   - l'émission (62), en présence d'un perturbateur magnétique, d'un champ magnétique par une source monoaxe située d'un côté du perturbateur magnétique, le moment magnétique de cette source étant connu,

   **caractérisé en ce que** le procédé comporte :

   - la détermination (64) d'une position et d'un moment magnétique d'une image de la source située de l'autre côté du perturbateur magnétique à partir d'une ou plusieurs mesures du champ magnétique émis réalisées par au moins un capteur magnétique dont la position et l'orientation par rapport à la source sont connues, la position et le moment magnétique de l'image minimisant la relation suivante pour chaque capteur :

   $$\vec{B}_{me} - ( \vec{B}_S + \vec{B}_I ) \ ,$$

   où :

   • $\vec{B}_{me}$ est le champ magnétique mesuré par le capteur en présence du perturbateur magnétique,
   • $\vec{B}_S$ est le champ magnétique qui serait mesuré par le capteur en absence du perturbateur magnétique, et
   • $\vec{B}_I$ est le champ magnétique fictif émis par l'image qui serait mesuré par le capteur en absence du perturbateur magnétique, et

   - la soustraction (74) du champ magnétique émis par cette image, construit à partir de la position et du moment magnétique de cette image, à la mesure du champ magnétique réalisée par un capteur en présence du perturbateur magnétique pour compenser cette mesure.

2. Procédé selon la revendication 1, dans lequel lors de la détermination (64) de la position et du moment magnétique de l'image au moins une relation supplémentaire issue de la théorie des images en électromagnétisme est utilisée, la ou les relations supplémentaires étant choisies dans l'ensemble suivant :

   -

$$M_i = M_S \left( \frac{1-\mu_r}{1+\mu_r} \right)\left( \frac{1-\sigma}{1+\sigma} \right) \quad \text{ou} \quad M_i = M_S \left( \frac{1-\mu_r}{1+\mu_r} \right) \quad \text{ou} \quad M_i = M_S \left( \frac{1-\sigma}{1+\sigma} \right),$$

où :

- $M_i$ et $M_s$ sont les moments magnétiques, respectivement, de l'image et de la source, et
- $\sigma$ et $\mu_r$ sont respectivement, la conductivité et la perméabilité relative du perturbateur magnétique,

- la distance la plus courte qui sépare la source du perturbateur magnétique est égale à la distance la plus courte qui sépare l'image de cette source du même perturbateur magnétique, et
- la composante normale du champ magnétique à la traversée d'une face du perturbateur magnétique est conservée de part et d'autre de cette face.

3. Procédé selon l'une quelconque des revendications précédentes, dans lequel le procédé comprend :

- la détermination (64) de la position et du moment magnétique d'une image de la source uniquement à partir de mesures du champ magnétique, en quadrature de phase par rapport au champ magnétique émis par cette source, réalisées par le ou les capteurs dont la position et l'orientation par rapport à la source sont connues, et
- la détermination (64) de la position et du moment d'une autre image de la même source uniquement à partir des mesures du champ magnétique, en phase avec le champ magnétique émis par cette source, réalisées par le ou les capteurs dont la position et l'orientation par rapport à la source sont connues.

4. Procédé selon l'une quelconque des revendications précédentes, dans lequel le procédé comprend le calcul du module efficace du champ magnétique à partir de mesures du champ magnétique en phase et en quadrature de phase par rapport au champ magnétique émis par la source, réalisées par le ou les capteurs dont la position et l'orientation par rapport à la source sont connues, et la détermination de la position et du moment magnétique d'au moins une image de la source à partir du module du champ magnétique.

5. Procédé selon l'une quelconque des revendications précédentes, dans lequel le procédé comprend :

- la détermination (64) de la position et du moment magnétique de plusieurs images de la même source à partir des mêmes mesures du champ magnétique réalisées par plusieurs capteurs dont les positions et les orientations sont connues par rapport à la source, et
- la soustraction (74) du champ magnétique émis par ces images à la mesure du champ magnétique réalisée par un capteur en présence du perturbateur magnétique pour compenser cette mesure.

6. Procédé selon l'une quelconque des revendications précédentes, dans lequel chaque image de la source est modélisée comme étant un dipôle magnétique.

7. Procédé de localisation d'un objet, ce procédé comportant :

- l'émission (72), en présence d'un perturbateur magnétique, d'un champ magnétique par une source monoaxe située d'un côté du perturbateur magnétique, le moment magnétique de cette source étant connu,
- la mesure (72) du champ magnétique émis par un capteur fixé sans aucun degré de liberté à l'objet,
- la localisation (74) de l'objet par rapport à la source à partir de la mesure de ce capteur,

**caractérisé en ce que** lors de la localisation, la mesure du capteur est compensée (74) à l'aide d'un procédé conforme à l'une quelconque des revendications précédentes.

8. Procédé selon la revendication 7, dans lequel la localisation (74) comporte la détermination des distances qui séparent le capteur à localiser de la source et de son ou ses images.

9. Support (50) d'enregistrement d'informations, **caractérisé en ce qu'**il comporte des instructions pour l'exécution d'un procédé conforme à l'une quelconque des revendications précédentes, lorsque ces instructions sont exécutées par un calculateur électronique.

**10.** Dispositif de compensation d'une mesure d'un champ magnétique, ce dispositif comportant :

- une source monoaxe (10) située d'un côté d'un perturbateur magnétique, cette source étant apte à émettre un champ magnétique en présence de ce perturbateur magnétique, le moment magnétique de cette source étant connu,

**caractérisé en ce que** le dispositif comporte également :

- au moins un capteur (10; 10, 94) du champ magnétique dont la position et l'orientation par rapport à la source magnétique sont connues,
- un compensateur (46) apte à :

• déterminer la position et le moment magnétique d'une image de la source située de l'autre côté du perturbateur magnétique à partir d'une ou plusieurs mesures du champ magnétique émis par la source réalisées par le ou les capteurs, la position et le moment magnétique de l'image minimisant la relation suivante pour chaque capteur : $\vec{B}_{me}$ - $(\vec{B}_S + \vec{B}_I)$, où :

- $\vec{B}_{me}$ est le champ magnétique mesuré par le capteur en présence du perturbateur magnétique,
- $\vec{B}_S$ est le champ magnétique qui serait mesuré par le capteur en absence du perturbateur magnétique, et
- $\vec{B}_I$ est le champ magnétique fictif émis par l'image qui serait mesuré par le capteur en absence du perturbateur magnétique, et

• à soustraire le champ magnétique émis par cette image, construit à partir de la position et du moment magnétique de cette image, à la mesure du champ magnétique réalisée par un capteur pour compenser cette mesure.

**11.** Système de localisation d'un objet, ce système comportant :

- au moins une source monoaxe (10) située d'un côté d'un perturbateur magnétique, cette source étant apte à émettre un champ magnétique en présence de ce perturbateur magnétique, le moment magnétique de cette source étant connu,
- au moins un capteur (40) du champ magnétique émis par la source, ce capteur étant fixé sans aucun degré de liberté à l'objet à localiser, et
- un module (44) de localisation de la position du capteur par rapport à la source à partir de la mesure du capteur,

**caractérisé en ce que** le système comporte un dispositif de compensation de la mesure utilisée par le module de localisation, conforme à la revendication 10.

**Patentansprüche**

**1.** Verfahren zur Kompensation einer Messung eines Magnetfeldes, wobei dieses Verfahren Folgendes umfasst:

- die Emission (62) eines Magnetfeldes bei Vorhandensein eines magnetischen Störers durch eine einachsige Quelle, die sich auf einer Seite des magnetischen Störers befindet, wobei das magnetische Moment dieser Quelle bekannt ist,

**dadurch gekennzeichnet, dass** das Verfahren Folgendes umfasst:

- die Bestimmung (64) einer Position und eines magnetischen Moments eines Bildes der Quelle, das sich auf der anderen Seite des magnetischen Störers befindet, ausgehend von einer oder mehreren Messungen des emittierten Magnetfeldes, die durch mindestens einen Magnetsensor ausgeführt wird/werden, dessen Position und Ausrichtung in Bezug auf die Quelle bekannt sind, wobei die Position und das magnetische Moment des Bildes die folgende Gleichung für jeden Sensor minimieren:

$$\vec{B}_{me} - (\vec{B}_S + \vec{B}_I) \quad ,$$

WO:

- $\vec{B}_{me}$ das durch den Sensor beim Vorhandensein des magnetischen Störers gemessene Magnetfeld ist,
- $\vec{B}_S$ das Magnetfeld ist, das durch den Sensor beim Nichtvorhandensein des magnetischen Störers gemessen würde, und
- $\vec{B}_I$ das fiktive durch das Bild emittierte Magnetfeld ist, das durch den Sensor beim Nichtvorhandensein des magnetischen Störers gemessen würde, und

- die Subtraktion (74) des durch dieses Bild emittierten Magnetfeldes, das ausgehend von der Position und dem magnetischen Moment dieses Bildes konstruiert wird, bei der Messung des Magnetfeldes, die durch einen Sensor beim Vorhandensein des magnetischen Störers ausgeführt wird, um diese Messung zu kompensieren.

2. Verfahren nach Anspruch 1, wobei bei der Bestimmung (64) der Position und des magnetischen Moments des Bildes mindestens eine zusätzliche Beziehung aus der Theorie der elektromagnetischen Bilder verwendet wird, wo die zusätzlichen Beziehungen in der folgenden Menge ausgewählt werden:

$$M_i = M_S \left(\frac{1-\mu_r}{1+\mu_r}\right)\left(\frac{1-\sigma}{1+\sigma}\right) \quad \text{oder} \quad M_i = M_S \left(\frac{1-\mu_r}{1+\mu_r}\right) \quad \text{oder} \quad M_i = M_S \left(\frac{1-\sigma}{1+\sigma}\right)$$

WO:

- $M_i$ und $M_s$ die magnetischen Momente des Bildes beziehungsweise der Quelle sind, und
- $\sigma$ und $\mu_r$ die Leitfähigkeit beziehungsweise die Permeabilitätszahl des magnetischen Störers sind,
- wobei der kürzeste Abstand, der die Quelle vom magnetischen Störer trennt, gleich dem kürzesten Abstand ist, der das Bild von dieser Quelle vom selben magnetischen Störer trennt, und
- die Normalkomponente des Magnetfeldes beim Durchqueren einer Fläche des magnetischen Störers auf beiden Seiten dieser Fläche bewahrt wird.

3. Verfahren nach einem der vorhergehenden Ansprüche, wobei das Verfahren ferner Folgendes umfasst:

- die Bestimmung (64) der Position und des magnetischen Moments eines Bildes der Quelle einzig ausgehend von Messungen des Magnetfeldes in Phasenquadratur in Bezug zum durch diese Quelle emittierten Magnetfeld, die durch den oder die Sensoren ausgeführt werden, dessen/deren Position und Ausrichtung in Bezug zur Quelle bekannt sind, und
- die Bestimmung (64) der Position und des Moments eines anderen Bildes derselben Quelle einzig ausgehend von Messungen des Magnetfeldes in Phase mit dem durch diese Quelle emittierten Magnetfeld, die durch den oder die Sensoren ausgeführt werden, dessen/deren Position und Ausrichtung in Bezug zur Quelle bekannt sind.

4. Verfahren nach einem der vorhergehenden Ansprüche, wobei das Verfahren die Berechnung des wirksamen Moduls des Magnetfeldes ausgehend von Messungen des Magnetfeldes in Phase und in Phasenquadratur in Bezug zum durch die Quelle emittierten Magnetfeld umfasst, die durch den oder die Sensoren ausgeführt werden, deren Position und Ausrichtung in Bezug zur Quelle bekannt sind, und die Bestimmung der Position und des magnetischen Moments von mindestens einem Bild der Quelle ausgehend von dem Modul des Magnetfeldes umfasst.

5. Verfahren nach einem der vorhergehenden Ansprüche, wobei das Verfahren Folgendes umfasst:

- die Bestimmung (64) der Position und des magnetischen Moments von mehreren Bildern derselben Quelle ausgehend von denselben Messungen des Magnetfeldes, die durch mehrere Sensoren ausgeführt werden, deren Positionen und Ausrichtungen in Bezug zur Quelle bekannt sind, und
- die Subtraktion (74) des durch diese Bilder emittierten Magnetfeldes bei der Messung des Magnetfeldes, die durch einen Sensor beim Vorhandensein des magnetischen Störers ausgeführt wird, um diese Messung zu kompensieren.

**6.** Verfahren nach einem der vorhergehenden Ansprüche, wobei jedes Bild der Quelle als ein magnetischer Dipol modelliert wird.

**7.** Verfahren zur Lokalisierung eines Objekts, wobei dieses Verfahren Folgendes umfasst:

- die Emission (72) eines Magnetfeldes bei Vorhandensein eines magnetischen Störers durch eine einachsige Quelle, die sich auf einer Seite des magnetischen Störers befindet, wobei das magnetische Moment dieser Quelle bekannt ist,
- die Messung (72) des emittierten Magnetfeldes durch einen ohne Freiheitsgrad an dem Objekt befestigten Sensor,
- die Lokalisierung (74) des Objekts in Bezug zur Quelle ausgehend von der Messung dieses Sensors, **dadurch gekennzeichnet, dass** bei der Lokalisierung die Messung des Sensors mittels eines Verfahrens nach einem der vorhergehenden Ansprüche kompensiert (74) wird.

**8.** Verfahren nach Anspruch 7, wobei die Lokalisierung (74) die Bestimmung der Entfernungen umfasst, die den zu lokalisierenden Sensor von der Quelle und von ihrem oder ihren Bild/ern trennt.

**9.** Träger (50) zum Aufzeichnen von Informationen, **dadurch gekennzeichnet, dass** er Befehle zur Ausführung eines Verfahrens nach einem der vorhergehenden Ansprüche umfasst, wenn diese Befehle durch einen elektronischen Rechner ausgeführt werden.

**10.** Vorrichtung zur Kompensation einer Messung eines Magnetfeldes, wobei diese Vorrichtung Folgendes umfasst:

- eine einachsige Quelle (10), die sich auf einer Seite eines magnetischen Störers befindet, wobei diese Quelle geeignet ist, um ein Magnetfeld beim Vorhandensein dieses magnetischen Störers zu emittieren, wobei das magnetische Moment dieser Quelle bekannt ist,

**dadurch gekennzeichnet, dass** die Vorrichtung ferner Folgendes umfasst:

- mindestens einen Magnetfeldsensor (10; 10, 94), dessen Position und Ausrichtung in Bezug zur Magnetquelle bekannt sind,
- einen Kompensator (46), der für Folgendes geeignet ist:

• Bestimmen der Position und des magnetischen Moments eines Bildes der Quelle, das sich auf der anderen Seite des magnetischen Störers befindet, ausgehend von einer oder mehreren Messungen des durch die Quelle emittierten Magnetfeldes, die durch den oder die Sensoren ausgeführt werden, wobei die Position und das magnetische Moment des Bildes die folgende Beziehung für jeden Sensor minimiert:

$$\vec{B}_{me} - (\vec{B}_S + \vec{B}_I) \ ,$$

WO:

- $\vec{B}_{me}$ das durch den Sensor beim Vorhandensein des magnetischen Störers gemessene Magnetfeld ist,
- $B_S$ das Magnetfeld ist, das durch den Sensor beim Nichtvorhandensein des magnetischen Störers gemessen würde, und
- $\vec{B}_I$ das fiktive durch das Bild emittierte Magnetfeld ist, das durch den Sensor beim Nichtvorhandensein des magnetischen Störers gemessen würde, und

• Subtrahieren des durch dieses Bild emittierten Magnetfeldes, das ausgehend von der Position und dem magnetischen Moment dieses Bildes konstruiert wird, bei der Messung des Magnetfeldes, die durch einen Sensor ausgeführt wird, um diese Messung zu kompensieren.

**11.** System zur Lokalisierung eines Objekts, wobei dieses System Folgendes umfasst:

- mindestens eine einachsige Quelle (10), die sich auf einer Seite eines magnetischen Störers befindet, wobei diese Quelle geeignet ist, beim Vorhandensein dieses magnetischen Störers ein Magnetfeld zu emittieren, wobei das magnetische Moment dieser Quelle bekannt ist,
- mindestens einen Sensor (40) für das durch die Quelle emittierte Magnetfeld, wobei dieser Sensor ohne Freiheitsgrad an dem zu lokalisierenden Objekt befestigt ist, und
- ein Modul (44) zur Lokalisierung der Position des Sensors in Bezug zur Quelle ausgehend von der Messung des Sensors, **dadurch gekennzeichnet, dass** das System eine Vorrichtung zur Kompensation der Messung nach Anspruch 10 umfasst, die durch das Lokalisierungsmodul verwendet wird.

**Claims**

**1.** A method for compensating a measurement of a magnetic field, said method comprising the following step:

- emitting (62) a magnetic field, in the presence of a magnetic disturber, by means of a uniaxial source situated on one side of the magnetic disturber, the magnetic moment of this source being known,

**characterised in that** the method comprises the following steps:

- determining (64) a position and a magnetic moment of an image of the source situated on the other side of the magnetic disturber using one or more measurements of the emitted magnetic field, the measurements being taken by at least one magnetic sensor, of which the position and the orientation relative to the source are known, the position and the magnetic moment of the image minimising the following relationship for each sensor:

$$\vec{B}_{\mathrm{me}} - \left( \vec{B}_S + \vec{B}_I \right) \ ,$$

where:

- $\vec{B}_{\mathrm{me}}$ is the magnetic field measured by the sensor in the presence of the magnetic disturber,
- $\vec{B}_S$ is the magnetic field that would be measured by the sensor in the absence of the magnetic disturber, and
- $\vec{B}_I$ is the fictitious magnetic field emitted by the image that would be measured by the sensor in the absence of the magnetic disturber, and

- subtracting (74) the magnetic field emitted by this image, constructed from the position and the magnetic moment of this image, from the measurement of the magnetic field taken by a sensor in the presence of the magnetic disturber, thereby compensating this measurement.

**2.** The method according to Claim 1, wherein, when determining (64) the position and the magnetic moment of the image, at least one supplementary relationship derived from electromagnetic image theory is used, the at least one supplementary relationship being chosen from the following set:

$$M_i = M_S \left( \frac{1 - \mu_r}{1 + \mu_r} \right) \left( \frac{1 - \sigma}{1 + \sigma} \right) \quad \mathrm{or} \quad M_i = M_S \left( \frac{1 - \mu_r}{1 + \mu_r} \right) \quad \mathrm{or} \quad M_i = M_S \left( \frac{1 - \sigma}{1 + \sigma} \right)$$

where:

- $M_i$ and $M_s$ are magnetic moments of the image and of the source respectively, and
- $\sigma$ and $\mu_r$ are the conductivity and relative permeability of the magnetic disturber respectively,
- the shortest distance between the source and the magnetic disturber is equal to the shortest distance between the image of this source and said magnetic disturber, and

- the normal component of the magnetic field at the crossing of one face of the magnetic disturber is kept on either side of this face.

3. The method according to one of the preceding claims, wherein said method further comprises the following steps:

- determining (64) the position and the magnetic moment of an image of the source solely from the measurements of the magnetic field, in quadrature relative to the magnetic field emitted by this source, the measurements being taken by the sensor or sensors, of which the position and orientation relative to the source are known, and
- determining (64) the position and the moment of another image of the same source solely from the measurements of the magnetic field, in phase with the magnetic field emitted by this source, the measurements being taken by the sensor or sensors, of which the position and orientation relative to the source are known.

4. The method according to one of the preceding claims, wherein the method comprises the steps ofcomputing the effective modulus of the magnetic field from measurements thereof, in phase and in quadrature relative to the magnetic field emitted by the source, the measurements being taken by the sensor or sensors, of which the position and orientation relative to the source are known; and determining the position and the magnetic moment of at least one image of the source from the modulus of the magnetic field.

5. The method according to one of the preceding claims, wherein the method comprises the following steps:

- determining (64) the position and magnetic moment of several images of the same source from the same magnetic field measurements, the measurements being taken by several sensors, of which the positions and orientations are known relative to the source, and
- subtracting (74) the magnetic field emitted by these images from the measurement of the magnetic field taken by a sensor in the presence of the magnetic disturber, thereby compensating this measurement.

6. The method according to one of the preceding claims, wherein each image of the source is modelled as a magnetic dipole.

7. A method for localising an object, said method comprising the following steps:

- emitting (72), in the presence of a magnetic disturber, a magnetic field by means of a uniaxial source situated on one side of the magnetic disturber, the magnetic moment of the source being known,
- measuring (72) the emitted magnetic field by means of a sensor fixed without any degree of freedom to the object,
- localising (74) the object relative to the source by means of the measurement taken by the sensor,

**characterised in that**, during the localisation process, the measurement taken by the sensor is compensated (74) using a method according to one of the preceding claims.

8. The method according to Claim 7, wherein the localisation process (74) comprises the determination of the distances separating the sensor to be localised from the source and from its image or images.

9. An information-recording medium (50), **characterised in that** it comprises instructions for the execution of a method according to one of the preceding claims when these instructions are executed by an electronic digital computer.

10. A device for compensating a measurement of a magnetic field, said device comprising:

- a uniaxial source (10) situated on one side of a magnetic disturber, this source being capable of emitting a magnetic field in the presence of the magnetic disturber, the magnetic moment of this source being known,

**characterised in that** the device also comprises:

- at least one sensor (10; 10, 94) of the magnetic field, the position and orientation of said sensor relative to the magnetic source being known,
- a compensator (46) capable of:

  • determining the position and the magnetic moment of an image of the source situated on the other side of the magnetic disturber through one or more measurements of the magnetic field emitted by the source, said one or more measurements being taken by the sensor or sensors, the position and the magnetic moment of the image minimising the following relationship for each sensor:

$$\vec{B}_{\mathrm{me}} - \left( \vec{B}_S + \vec{B}_I \right) \ ,$$

where:

- $\vec{B}_{\mathrm{me}}$ is the magnetic field measured by the sensor in the presence of the magnetic disturber,
- $\vec{B}_S$ is the magnetic field that would be measured by the sensor in the absence of the magnetic disturber, and
- $\vec{B}_I$ is the fictitious magnetic field emitted by the image that would be measured by the sensor in the absence of the magnetic disturber, and

• subtracting the magnetic field emitted by this image, constructed from the position and the magnetic moment of the image, from the measurement of the magnetic field taken by the sensor, thereby compensating this measurement.

11. A system for localising an object, said system comprising:

- at least one uniaxial source (10) situated on one side of a magnetic disturber, said source being capable of emitting a magnetic field in the presence of this magnetic disturber, the magnetic moment of this source being known,
- at least one sensor (40) of the magnetic field emitted by the source, this sensor being fixed without any degree of freedom to the object to be localised, and
- a module (44) for localising the position of the sensor relative to the source through the measurement of the sensor, **characterised in that** the system comprises a device according to claim 10 for compensating the measurement used by the localisation module.

Fig. 1

Fig. 2

Fig. 3

Fig. 5

Fig. 6

Fig. 7

Fig. 4

## RÉFÉRENCES CITÉES DANS LA DESCRIPTION

**Documents brevets cités dans la description**

- US 5134369 A
- WO 2009138441 A1
- US 2008309327 A1
- US 5182514 A
- US 6528989 B
- EP 1502544 A

**Littérature non-brevet citée dans la description**

- **I. LINDELL.** Exact image Theory for the Sommerfield Half-space problem, part I : Vertical Magnetic Dipole. *IEEE Transactions on Antennas and Propagation,* Février 1984, vol. AP-32 (2
- **I. LINDELL.** Exact Image Theory for the Sommerfield Half-space problem, part 111: General Formulation. *IEEE Transactions on Antennas and propagation,* Octobre 1984, vol. AP-32 (10